# EUROPEAN PATENT SPECIFICATION

(11) **EP 4 439 562 B1**
(45) Date of publication and mention of the grant of the patent: **06.05.2026**
(21) Application number: 24164846.8
(22) Date of filing: 12.03.2024
(51) Int. Cl.: G11C 13/00, H10B 63/00, H10N 70/20, H10N 70/00

(54) **SELF-SELECTING MEMORY DEVICE HAVING POLARITY DEPENDENT THRESHOLD VOLTAGE SHIFT CHARACTERISTICS AND MEMORY APPARATUS INCLUDING THE SAME**
SELBSTAUSWÄHLENDE SPEICHERVORRICHTUNG MIT POLARITÄTSABHÄNGIGEN SCHWELLENSPANNUNGSVERSCHIEBUNGSEIGENSCHAFTEN UND SPEICHERVORRICHTUNG DAMIT
DISPOSITIF DE MÉMOIRE À SÉLECTION AUTOMATIQUE AYANT DES CARACTÉRISTIQUES DE DÉCALAGE DE TENSION DE SEUIL DÉPENDANT DE LA POLARITÉ ET APPAREIL DE MÉMOIRE LE COMPRENANT

(30) Priority: 24.03.2023 KR 20230039310; 30.06.2023 KR 20230085275; 22.02.2024 KR 20240026041
(43) Date of publication of application: 02.10.2024
(62) Divisional of application: 24162909.6
(73) Proprietor: Samsung Electronics Co., Ltd., Suwon-si, Gyeonggi-do 16677 (KR)
(72) Inventor: YANG, Kiyeon, 16678, Suwon-si (KR); GU, Dongggeon, 18448, Hwaseong-si (KR); KOO, Bonwon, 16678, Suwon-si (KR); PARK, Jeonghee, 18448, Hwaseong-si (KR); SUNG, Hajun, 16678, Suwon-si (KR); AHN, Dongho, 18448, Hwaseong-si (KR); WUN, Zhe, 18448, Hwaseong-si (KR); LEE, Changseung, 16678, Suwon-si (KR); CHOI, Minwoo, 16678, Suwon-si (KR)
(74) Representative: Elkington and Fife LLP

(56) References cited:
- KR-A- 20210 153 275
- US-A1- 2023 058 092
- BAN SANGHYUN ET AL: "Pulse Dependent Threshold Voltage Variation of the Ovonic Threshold Switch in Cross-Point Memory", IEEE ELECTRON DEVICE LETTERS, IEEE, USA, vol. 41, no. 3, 28 January 2020 (2020-01-28), pages 373 - 376, XP011774251, ISSN: 0741-3106, [retrieved on 20200225], DOI: 10.1109/LED.2020.2969962

## Description

### FIELD OF THE INVENTION

Various example embodiments relate to a self-selecting memory device having polarity dependent threshold voltage shift characteristics and/or to a memory apparatus including the self-selecting memory device.

### BACKGROUND OF THE INVENTION

Along with the miniaturization of electronic products, there is an increasing demand for high-density memory devices. A cross-point memory device has a memory structure in which an upper electrode and a lower electrode are arranged vertically crossing each other and a memory cell is disposed at an intersection area. The structure has a merit of having a small memory cell on a plane. Generally, in order to prevent or reduce the likelihood of a sneak current between neighboring memory cells, a memory cell in a cross-point memory apparatus includes a 2-terminal selector and a memory device, which are connected to each other in series. Therefore, an aspect ratio of a unit memory cell may increase too much so that the manufacturing process of a memory cell is complicated and there is a limitation in increasing the memory capacity of a memory apparatus.

Korean Patent Application Number KR 2021 0153275 A describes an electronic device comprising a memory cell in which a chalcogenide film and at least one threshold voltage adjustment film are stacked.

### SUMMARY OF THE INVENTION

Various example embodiments provide a self-selecting memory device having both a selector function and a memory function using polarity dependent threshold voltage shift characteristics and a memory apparatus including the self-selecting memory device.

Additional aspects will be set forth in part in the description which follows and, in part, will be apparent from the description, or may be learned by practice of variously described example embodiments.

According to some example embodiments, there is provided a memory apparatus according to claim 1.

Some embodiments propose self-selecting memory (SSM) using a polarity dependent Vth shift mechanism. Such a SSM can be applied as the cross-point memory device because it has a simple device structure and can simultaneously implement memory and selector functions with a single device, but it can also be applied as a vertical device that can dramatically increase memory capacity. When applied to the vertical device, the hole diameter can be reduced due to the simplicity of the components, which is advantageous for increasing memory density.

There is proposed a technology to realize the Self-Selecting Memory by generating a Vth shift using only a change in the trap state without causing migration of components inside the OTS. The OTS is a material that has many trap states inside and generates a threshold switching phenomenon by them. When a negative bias opposite to the first-firing (F.F) driving bias is applied to the OTS, the trap state in the OTS changes from an activated state to a de-activated state, and a Vth shift phenomenon occurs when a positive bias is subsequently applied. By utilizing the Vth shift phenomenon of the OTS material, it is possible to realize a self-selecting memory that has both selector and memory characteristics.

Embodiments may provide a self-selecting memory in which Vth shift occurs due to a phenomenon that the trap state changes depending on a polarity of an electric field.

Some embodiments may provide a self-selecting memory in which a deep trap is generated/destroyed in a region near electrode/SSM and a Vth shift is generated by changing a polarity of an electric field.

Embodiments may provide a device in which a Vth of the SSM changes by forming an interfacial tunneling barrier (ITB) at an interface with the electrode according to a polarity of a bias applied when writing to the GeAsSe-based SSM device.

Some embodiments may provide a SSM device utilizing a fact that the Vth increases due to formation of an ITB at the interface with a top electrode when a bias opposite to F.F. is applied after the F.F bias is applied, and the Vth shift occurs due to a polarity of an applied bias.

Alternatively or additionally according to various example embodiments, a memory apparatus includes a plurality of bit lines extending in a first direction, a plurality of word lines extending in a second direction crossing the first direction, and a plurality of memory cells at intersections between the plurality of bit lines and the plurality of word lines. The plurality of memory cells each have Ovonic threshold switching characteristics, the plurality of memory cells are each configured to have threshold voltages of the plurality of memory cells each be changed as a density of active traps in the plurality of memory cells is changed, the threshold voltages changed according to a polarity of and an intensity of a bias voltage applied to respective ones of the plurality of memory cells An element composition distribution is configured to be maintained constant in the memory layer in response to the threshold voltage of the memory layer being changed.

Alternatively or additionally according to various example embodiments, a memory apparatus includes a plurality of word planes extending along a plane defined by a first direction and a second direction and apart from each other in a third direction crossing the first direction and the second direction, a plurality of vertical bit lines extending in the third direction and arranged two-dimensionally in the first direction and the second direction, and a plurality of memory cell strings surrounding surfaces of the plurality of vertical bit lines and extending in the third direction. The plurality of memory cell strings and the plurality of vertical bit lines are arranged to penetrate the plurality of word planes in the third direction. An area surrounded by one of the plurality of word planes in each of the plurality of memory cell strings corresponds to one memory cell, the memory cell may have Ovonic threshold switching characteristics, the memory cell may be configured to have a threshold voltage of the memory cell be changed as a density of active traps in the memory cell is changed, the threshold voltage changed according to a polarity of and an intensity of a bias voltage applied to the memory cell, An element composition distribution is configured to be maintained constant in the memory layer in response to the threshold voltage of the memory layer being changed.

### BRIEF DESCRIPTION OF THE DRAWINGS

These and/or other aspects will become apparent and more readily appreciated from the following description of various example embodiments, taken in conjunction with the accompanying drawings in which:
FIG. 1 is a schematic cross-sectional view of the structure of a memory device according to various example embodiments;
FIG. 2 is a graph showing an example of current-voltage characteristics of a memory layer of a memory device according to various example embodiments;
FIG. 3A is a graph showing an example of a bias voltage for a set (SET) operation and a read operation in a memory device according to various example embodiments;
FIG. 3B is a graph showing an example of a bias voltage for a reset (RESET) operation and a read operation in a memory device according to various example embodiments;
FIG. 4A is a conceptual view of an example of a trap state in a memory layer in a pristine state of the memory layer of a memory device according to various example embodiments, and FIG. 4B is a schematic energy band diagram of the memory layer in the pristine state;
FIG. 5A is a conceptual view of an example of a trap state in a memory layer after a positive (+) bias voltage for first-firing is applied to the memory layer in a pristine state, FIG. 5B is a schematic energy band diagram of a region of the memory layer around a first electrode after the first-firing, and FIG. 5C is a schematic energy band diagram of a region of the memory layer around a second electrode after the first-firing;
FIG. 6A is a conceptual view of an example of a trap state in a memory layer after a negative (-) bias voltage is applied to the first-fired memory layer, FIG. 6B is a schematic energy band diagram of the region of the memory layer around the first electrode after the negative bias voltage is applied, and FIG. 6C is a schematic energy band diagram of the region of the memory layer around the second electrode after the negative bias voltage is applied;
FIGS. 7 and 8 are graphs respectively showing comparative examples of trap densities in the memory layer in the pristine state, after the first-firing and after the application of a negative bias voltage;
FIG. 9 is a graph showing an example of a relationship between a threshold voltage of a memory layer and the intensity and pulse width of a bias voltage;
FIG. 10 is a graph showing an example of a threshold voltage of a memory layer when fixing the intensity of a bias voltage and changing a pulse width of the bias voltage;
FIGS. 11A, 11B, 11C, 11D, 11E, and 11F are graphs showing examples of a change in the difference between a threshold voltage of a memory layer in a first state and a threshold voltage of a memory layer in a second state when a reset operation and a set operation are repeatedly performed by using a bias voltage having various pulse widths;
FIG. 12 is a graph showing an example of an element composition ratio of a material of a memory layer according to various example embodiments;
FIG. 13 illustrates an example of a transmission electron microscope (TEM) image of an actually manufactured memory device;
FIGS. 14A, 14B, and 14C illustrate an example of an element mapping result with respect to a memory layer of the memory device of FIG. 13;
FIG. 15 illustrates examples of a bottom region, a middle region, and a top region that equally divide a memory layer according to various example embodiments into three parts with the same thickness;
FIG. 16 illustrates an example of the concentration of selenium in the bottom region, the middle region, and the top region of three actually manufactured memory layer samples;
FIG. 17 is a schematic perspective view of the structure of a memory apparatus according to various example embodiments;
FIG. 18 is a circuit diagram of an example of an operation of selecting a specific memory cell in the memory apparatus illustrated in FIG. 17;
FIG. 19 is a schematic perspective view of the structure of a memory apparatus according to another embodiment;
FIG. 20 is a schematic vertical cross-sectional view of the configuration of one memory cell in the memory apparatus illustrated in FIG. 19;
FIG. 21 is a schematic horizontal cross-sectional view of the configuration of one memory cell in the memory apparatus illustrated in FIG. 19; and
FIG. 22 is a schematic conceptual view of a device architecture applicable to an example electronic apparatus.

### DETAILED DESCRIPTION

Reference will now be made in detail to various embodiments, examples of which are illustrated in the accompanying drawings, wherein like reference numerals refer to like elements throughout. In this regard, example embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinbelow, a self-selecting memory device using a polarity dependent threshold voltage shift method, and a memory apparatus including the same, are described in detail with reference to the accompanying drawings. Throughout the drawings, like reference numerals denote like elements, and sizes of components in the drawings may be exaggerated for convenience of explanation and clarity. Furthermore, as embodiments described below are examples, other modifications may be produced from the embodiments.

When a constituent element is disposed "above" or "on" to another constituent element, the constituent element may include not only an element directly contacting and disposed on the other constituent element, but also an element disposed above the other constituent element in a non-contact manner. As used herein, the singular forms "a," "an," and "the" are intended to include the plural forms as well, unless the context clearly indicates otherwise. It will be further understood that the terms "comprises" and/or "comprising" used herein specify the presence of stated features or components, but do not preclude the presence or addition of one or more other features or components.

The use of the terms "a" and "an" and "the" and similar referents in the context of describing the disclosure are to be construed to cover both the singular and the plural. Also, the steps of all methods described herein can be performed in any suitable order unless otherwise indicated herein or otherwise clearly contradicted by context. The disclosure is not limited to the described order of the steps.

Furthermore, terms such as "... portion," "... unit," "... module," and "... block" stated in the specification may signify a unit to process at least one function or operation and the unit may be embodied by hardware, software, or a combination of hardware and software.

Furthermore, the connecting lines, or connectors shown in the various figures presented are intended to represent functional relationships and/or physical or logical couplings between the various elements. It should be noted that many alternative or additional functional relationships, physical connections or logical connections may be present in a practical device.

The use of any and all examples, or language (e.g., "such as") provided herein, is intended merely to better illuminate the disclosure and does not pose a limitation on the scope of the disclosure unless otherwise claimed.

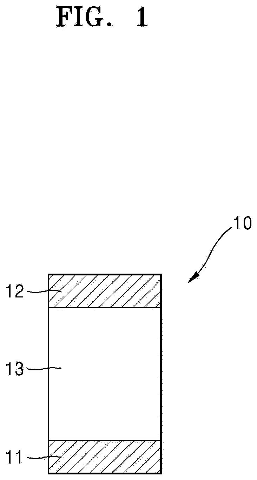

FIG. 1 is a schematic cross-sectional view of the structure of a memory device 10 according to various example embodiments. Referring to FIG. 1, the memory device 10 may include a first electrode 11, a second electrode 12 arranged apart from the first electrode 11 to face each other, and a memory layer 13 arranged between the first electrode 11 and the second electrode 12.

The first electrode 11 and the second electrode 12 may function to apply a voltage to the memory layer 13. In some example embodiments, the first electrode 11 and the second electrode 12 may each independently include a metal, a conductive metal nitride, a conductive metal oxide, or a combination thereof. For example, the first electrode 11 and the second electrode 12 may each independently include at least one of a titanium nitride (TiN), a titanium silicon nitride (TiSiN), a titanium carbon nitride (TiCN), a titanium carbon silicon nitride (TiCSiN), a titanium aluminum nitride (TiAIN), tantalum (Ta), a tantalum nitride (TaN), a tantalum silicon nitride (TaSiN), a tantalum aluminum nitride (TaAIN), a tungsten silicide (WSi), tungsten titanium (TiW), a molybdenum nitride (MoN), a niobium nitride (NbN), a titanium boron nitride (TiBN), a zirconium silicon nitride (ZrSiN), a tungsten silicon nitride (WSiN), a tungsten boron nitride (WBN), a zirconium aluminum nitride (ZrAlN), a molybdenum aluminum nitride (MoAIN), a titanium aluminide (TiAl), a titanium oxynitride (TiON), a titanium aluminum oxynitride (TiAlON), a tungsten oxynitride (WON), a tantalum oxynitride (TaON), a silicon carbide (SiC), a silicon carbo nitride (SiCN), a carbon nitride (CN), a tantalum carbon nitride (TaCN), tungsten (W), a tungsten nitride (WN), and carbon (C), or a combination thereof. In some example embodiments, the first electrode 11 may include the same (e.g., exactly the same) material as the second electrode 12; however, example embodiments are not limited thereto, and the first electrode 11 and/or the second electrode 12 may include different elements from the other.

The memory layer 13 may have an Ovonic threshold switching (OTS) characteristic having a high resistance state when a voltage less than (e.g., less in absolute value than) a threshold voltage is applied thereto and having a low resistance state when a voltage greater than (e.g., greater in absolute value than) the threshold voltage is applied thereto. Furthermore, the memory layer 13 may have the characteristics of a memory whose threshold voltage is shifted according to the polarity and/or the intensity of an applied bias voltage. Accordingly, the memory layer 13 may have the characteristics of a self-selecting memory that may perform both of a memory function and a selector function with a single material only. To this end, the memory layer 13 may include a single material of a multi-component chalcogenide. For example, the memory layer 13 may include a single layer including at least one material of GeAsSe, GeAsSeln, GeAsSeSIn, GeAsSeSb, GeAsSeSbIn, GeAsSeTe, GeAsSeTeln, GeAsSeAl, GeAsSeAlln, GeSbSe, GeSbSeln, GeSbSeN, and GeSbSeNIn.

For example, the memory layer 13 may include a single layer such as GeAsSe having indium doped therein. For example, the memory alyer 13 may include at least one material of GeAsSeln, GeAsSeSIn, and GeAsSeAlln. For example, when the memory layer 13 includes indium (In) doped or incorporated therein, for example at an atomic concentration of 10%, there may be an increase in off-current leakage. However it may be seen experimentally that a resistance and Vth drift characteristics of such In-based devices may be dramatically improved and delta-Vth maintain with a similar value. Additionally or alternatively in some example embodiments there may not be any silicon (Si) in the memory layer 13. For example, when the memory layer 13 does not include any silicon (Si), there may be an improvement in, e.g., a reduction of leakage current.

In some example embodiments, electrical performance may vary depending upon an atomic concentration of In included in the memory layer 13. For example, table 1 reviews electrical performance, including leakage current (Ioff), drift (Drift), and threshold voltage shift (△Vth) when various concentrations of indium (In) are included in (e.g., doped in or otherwise incorporated in) a memory layer 13 comprising GeAsSeln. The values are normalized to an indium concentration of 0 at%. The atomic concentration of In included in the memory layer 13 may be determined based on table 1. For example, the atomic concentration of In included in the memory layer 13 may be about 10 at% or less. In particular, the atomic concentration of In included in the memory layer 13 may be about 1 at% or more and about 8 at% or less, or about 3 at% or more and about 5 at% or less.

**Table 1:**

| | In 0 at% | In 1 at% | In 3 at% | In 5 at% | In 8 at% | In 10 at% |
|---|---|---|---|---|---|---|
| Ioff | 1.00 | 2.00 | 2.68 | 3.04 | 30.50 | 188.50 |
| Drift | 1.00 | 0.48 | 0.44 | 0.29 | 0.48 | 0.50 |
| ΔVth | 1.00 | 0.76 | 0.85 | 0.93 | 1.22 | 1.07 |

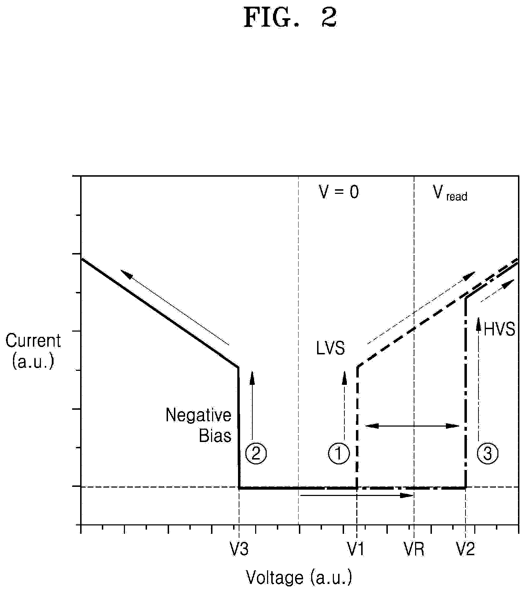

FIG. 2 is a graph showing an example of current-voltage (IV) characteristics of the memory layer 13 of the memory device 10 according to various example embodiments. Referring to FIG. 2, the memory layer 13 may have or be in any one of a first state (LVS; a low Vth state) in which a threshold voltage is relatively low or low in absolute value and a second state (HVS; a high Vth state) in which the threshold voltage is relatively high or high in absolute value. For example, in the first state, the threshold voltage of the memory layer 13 may be a first voltage of V1, and in the second state, the threshold voltage of the memory layer 13 may be a second voltage of V2 that is greater than the first voltage of V1. When the memory layer 13 is in the first state and a voltage less than the first voltage of V1 is applied to the memory layer 13, a current hardly flows between the opposite ends of the memory layer 13, and when a voltage greater than the first voltage of V1 is applied to the memory layer 13, the memory layer 13 is turned on so that a current flows through the memory layer 13. Additionally or alternatively, when the memory layer 13 is in the second state, and a voltage less than the second voltage of V2 is applied to the memory layer 13, a current hardly flows between the opposite ends of the memory layer 13, and when a voltage greater than the second voltage of V2 is applied to the memory layer 13, the memory layer 13 is turned on so that a current flows through the memory layer 13.

Accordingly, a voltage between the first voltage of V1 and the second voltage of V2 may be selected as a read voltage of VR. When the memory layer 13 is in the first state, and the read voltage of VR is applied to the memory layer 13, a current flows through the memory layer 13, and in this state, a data value stored in the memory layer 13 may be defined to be a first binary or logical value, such as but not limited to "1". When the memory layer 13 is in the second state, and the read voltage of VR is applied to the memory layer 13, a current hardly flows through the memory layer 13, and in this state, the data value stored in the memory layer 13 may be defined to be a second binary or logical value, such as but not limited to "0". In some example embodiments, the data value stored in the memory layer 13 may be read by measuring a current flowing in the memory layer 13 while the read voltage of VR is applied to the memory layer 13.

When the memory layer 13 is in the first state, and a negative (-) bias voltage is applied to the memory layer 13, the threshold voltage of the memory layer 13 is increased so that the state of the memory layer 13 may be converted into the second state. For example, when a negative third voltage of V3 is applied to the memory layer 13, the memory layer 13 may be converted into the second state. Such an operation may be referred to as a reset (RESET) operation or an erase operation. Furthermore, when the memory layer 13 is in the second state, and a positive (+) bias voltage greater than the second voltage of V2 is applied to the memory layer 13, the threshold voltage of the memory layer 13 is decreased so that the memory layer 13 may be converted into the first state. Such an operation may be referred to as a set (SET) operation or a program operation.

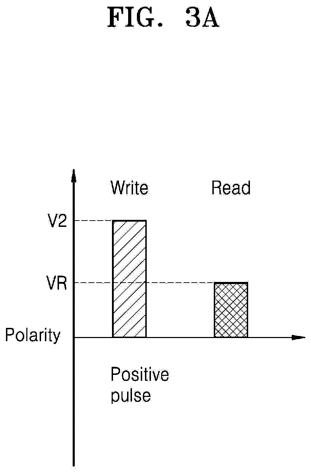

FIG. 3A is a graph showing an example of a bias voltage for the set (SET) operation and the read operation in the memory device 10 according to various example embodiments. Referring to FIG. 3A, in the set (SET) operation, a positive bias voltage that is greater than or equal to the second voltage of V2 may be applied to the memory layer 13. Then, the threshold voltage of the memory layer 13 may be shifted to the first voltage of V1. Thereafter, in the read operation, a positive read voltage of VR between the first voltage of V1 and the second voltage of V2 may be applied to the memory layer 13. When the read voltage of VR is applied, the memory layer 13 may be turned on.

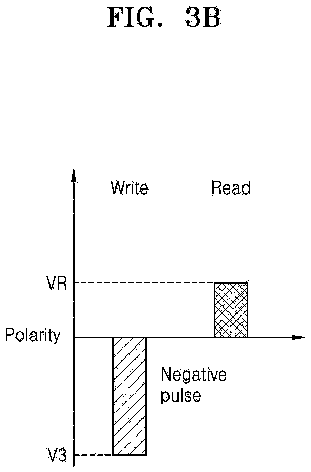

FIG. 3B is a graph showing an example of a bias voltage for the reset (RESET) operation and the read operation in the memory device 10 according to various example embodiments. Referring to FIG. 3B, in the reset (RESET) operation, a negative bias voltage, for example, the third voltage of V3, may be applied to the memory layer 13. The absolute value of the third voltage of V3 may be approximately equal to or slightly greater or less than the second voltage of V2. Then, the threshold voltage of the memory layer 13 may be shifted to the second voltage of V2 greater than the first voltage of V1. Thereafter, in the read operation, the positive read voltage of VR between the first voltage of V1 and the second voltage of V2 may be applied to the memory layer 13. When the read voltage of VR is applied, the memory layer 13 may be turned off.

As described above, the memory layer 13 of the memory device 10 according to various example embodiments may have an Ovonic threshold switching characteristics and may simultaneously have the characteristics of a memory in which the threshold voltage is changed. For example, the threshold voltage of the memory layer 13 may be shifted according to the polarity of a bias voltage applied to the memory layer 13. In this regard, the memory device 10 according to various example embodiments may be a self-selecting memory device having polarity dependent threshold voltage shift characteristics.

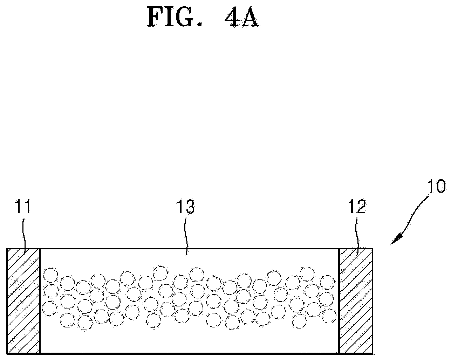

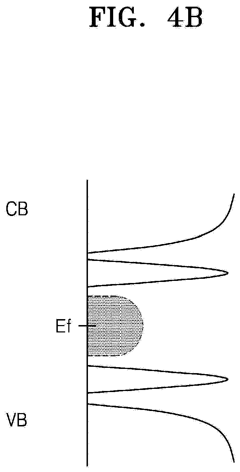

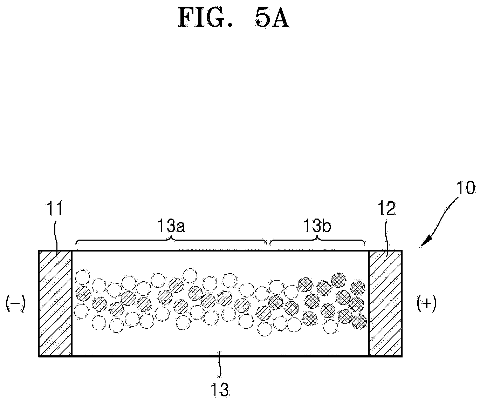

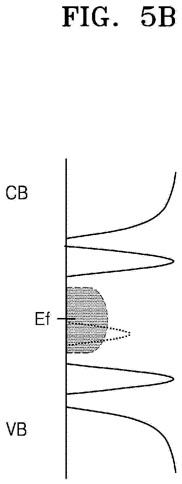

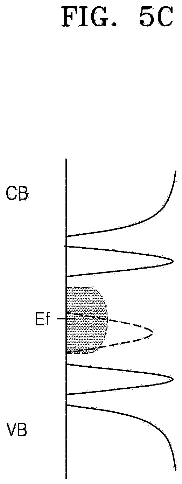

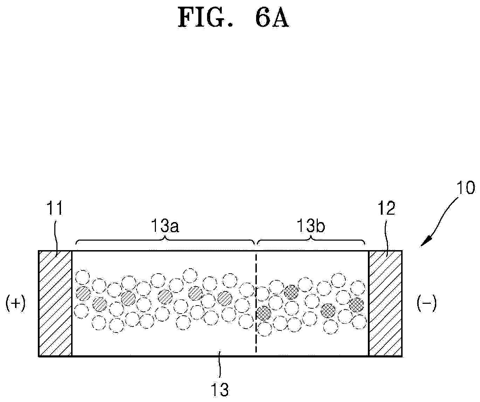

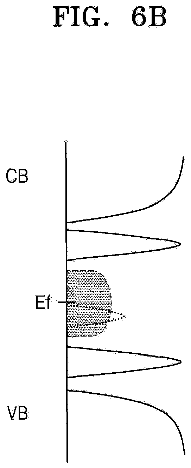

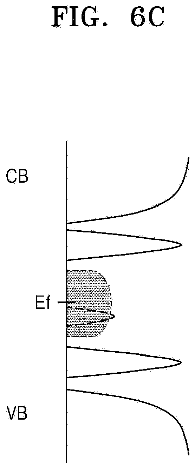

Such a polarity dependent threshold voltage shift behavior may be described through a trap state change in the memory layer 13. FIGS. 4A to 6B are views for conceptually describing a trap state change in the memory layer 13. In particular, FIG. 4A is a conceptual view of an example of a trap state in the memory layer 13 in a pristine state of the memory layer 13 of the memory device 10 according to various example embodiments, and FIG. 4B is a schematic energy band diagram or Fermi diagram of the memory layer 13 in the pristine state. FIG. 5A is a conceptual view of an example of a trap state in the memory layer 13 after a positive (+) bias voltage for first-firing is applied to the memory layer 13 in the pristine state, FIG. 5B is a schematic energy band diagram or Fermi diagram of a region of the memory layer 13 around the first electrode 11 after the first-firing, and FIG. 5C is a schematic energy band diagram or Fermi diagram of a region of the memory layer 13 around the second electrode 12 after the first-firing. FIG. 6A is a conceptual view of an example of a trap state in the memory layer 13 after a negative (-) bias voltage is applied to the memory layer 13 that is first-fired, FIG. 6B is a schematic energy band diagram of the region of the memory layer 13 around the first electrode 11 after the application of a negative bias voltage, and FIG. 6C is a schematic energy band diagram of the region of the memory layer 13 around the second electrode 12 after the application of a negative bias voltage.

Referring to FIG. 4A, de-activated traps are mainly present in the memory layer 13 in the pristine state just after manufacturing or fabrication of the semiconductor device. For convenience of explanation, in FIG. 4A, the de-activated traps are indicated by dashed circles. The de-activated traps may be mainly formed by covalent bonds (Se-Se) between neighboring selenium (Se) atoms in or within the memory layer 13.

Furthermore, in the graph of FIG. 4B, "CB" may denote a conduction band, "VB" denotes a valence band, and the horizontal axis indicates the density of a state. Referring to FIG. 4B, an energy band formed by the de-activated traps is indicated by a thin dashed line. The energy band indicated by a solid line in FIG. 4B is formed by other materials in the memory layer 13. The energy band formed by the de-activated traps may be distributed around a Fermi level Ef.

A positive (+) bias voltage may be applied to first-fire the memory layer 13 in the pristine state. For example, a bias voltage may be applied to the memory layer 13 so that a current flows from the second electrode 12 toward the first electrode 11. Referring to FIG. 5A, active traps may be formed as some of the de-activated traps are activated by the first-firing. The active traps may be formed, e.g., may be mainly formed by Se ions (Se²⁻) that are generated as the covalent bonds between the Se atoms are broken. A percolation path or conductive path may be formed in the memory layer 13 by these active traps, and as the percolation path is formed, the threshold voltage of the memory layer 13 may be lowered.

In FIG. 5A, the active traps are indicated by circles of a hatch pattern and circles of a net pattern. As illustrated in FIG. 5A, the amount of active traps in the memory layer 13 may increase from the first electrode 11 toward the second electrode 12. In particular, the active traps may be generated in a large amount in the area of the memory layer 13 close to the second electrode 12. Accordingly, after the first-firing, the memory layer 13 may include a first region 13a in which the density of active traps is relatively low and a second region 13b in which the density of active traps is relatively high. The thickness of the second region 13b may be less than the thickness of the first region 13a. For example, the total thickness of the memory layer 13 may be about 10 nm or more and about 30 nm or less, and the thickness of the second region 13b may be about 1 nm or more and about 4 nm or less; however, example embodiments are not limited thereto.

The first region 13a may be or may correspond to an area adjacent to the first electrode 11. The active traps in the first region 13a are indicated by circles of a hatch pattern. The density of active traps in the first region 13a may slightly increase toward a boundary with the second region 13b, but an increment thereof may be relatively small. The second region 13b may be or may correspond to an area adjacent to the second electrode 12. Furthermore, the second region 13b may be in direct contact with the first region 13a and may be disposed between the first region 13a and the second electrode 12. The active traps in the second region 13b are indicated by circles of a net or hash pattern. The density of active traps in the second region 13b may be increased relatively greatly closer to the boundary with the second electrode 12. Accordingly, the density of active traps in the second region 13b may be greater than the density of active traps in the first region 13a. In this case, the memory layer 13 is in the first state in which the threshold voltage is relatively low. For example, when the memory layer 13 is in the first state, the density of active traps in the second region 13b is greater than the density of active traps in the first region 13a.

Referring to FIG. 5B, an energy band formed by active traps in the first region 13a is indicated by a dotted line. The energy band formed by active traps may be located at an energy level that is slightly lower than the Fermi level Ef. Furthermore, referring to FIG. 5C, the energy band formed by active traps in the second region 13b is indicated by a thick dashed line. When comparing FIG. 5B with FIG. 5C, it may be seen that the energy band formed by active traps in the second region 13b has an energy distribution that is slight greater than or slightly wider than the energy band formed by the active traps in the first region 13a. Furthermore, it may be seen that the density of a state of active traps in the second region 13b is greater than the density of a state of active traps in the first region 13a. Accordingly, it may be seen that the amount of active traps in the second region 13b is greater than the amount of active traps in the first region 13a.

The high the density of active traps around the second electrode 12 after the first-firing may have a great effect on a shift behavior of the threshold voltage of the memory layer 13. For example, the density of active traps in the second region 13b may be relatively easily changed according to the polarity of a bias voltage. Accordingly, the threshold voltage of the memory layer 13 may be relatively easily shifted, which may lead to a relatively easy SET operation and/or a relatively easy RESET operation.

When a negative (-) bias voltage is applied to the memory layer 13 that is first-fired, for example, when a bias voltage is applied to the memory layer 13 in the reverse direction so that a current flows from the first electrode 11 toward the second electrode 12, some of the active traps in the second region 13b close to the second electrode 12 are annihilated and changed to de-activated traps. This may be described such that Se ions (Se²⁻) neighboring each other are bonded again to form covalent bonds (Se-Se). As a result, the density of active traps in the memory layer 13 may be reduced.

When comparing FIG. 5A with FIG. 6A, after a negative bias voltage is applied to the memory layer 13, the density of active traps may be reduced in both of the first region 13a and the second region 13b. **In** particular, the density of active traps may be greatly reduced in the second region 13b. In contrast, a change amount in the density of active traps in the first region 13a may be less than a change amount in the density of active traps in the second region 13b. Accordingly, after a negative bias voltage is applied to the memory layer 13, the density of active traps in the second region 13b may be less than the density of active traps in the first region 13a. Therefore, an interface tunneling barrier (ITB) may be formed around the boundary between the first region 13a and the second region 13b.

Furthermore, when comparing FIG. 5B with FIG. 6B, after a negative bias voltage is applied to the memory layer 13, the density of a state of active traps in the first region 13a may be slightly reduced. **In** contrast, when comparing FIG. 5C and FIG. 6C, after a negative bias voltage is applied to the memory layer 13, the density of a state of active traps in the second region 13b may be relatively greatly reduced. Furthermore, when comparing FIG. 6B with FIG. 6C, it may be seen that, after a negative bias voltage is applied to the memory layer 13, a peak of the density of states of active traps in the second region 13b is less than a peak of the density of states of active traps in the first region 13a.

When the amount of active traps is reduced in the memory layer 13, in particular in the second region 13b close to the second electrode 12, a greater bias voltage is necessary to form an electrical conduction path. Accordingly, the threshold voltage of the memory layer 13 may be increased. **In** this state, the memory layer 13 may be in the second state in which the threshold voltage is relatively high. **In** other words, when the memory layer 13 is in the second state, the density of active traps in the second region 13b may be less than the density of active traps in the first region 13a. Furthermore, when the memory layer 13 is in the second state, the density of active traps in the first region 13a and the density of active traps in the second region 13b may be respectively less than the density of active traps in the first region 13a and the density of active traps in the second region 13b when the memory layer 13 is in the first state.

Thereafter, when a positive bias voltage greater than or equal to the threshold voltage is applied to the memory layer 13, the amount of active traps in the memory layer 13, in particular in the second region 13b, increases, and thus, the threshold voltage of the memory layer 13 may be reduced again. Then, the memory layer 13 may be in the first state again. As such, in the memory device 10 according to various example embodiments, through a state change of active traps in the memory layer 13, for example through a great state change in the active traps in the second region 13b of the memory layer 13 close to the second electrode 12, a threshold voltage shift behavior may be implemented. As the density of active traps in a pristine state is less than the density of active traps in a state in which a negative bias voltage is applied after the first-firing, a positive bias voltage needed for first-firing may be greater than a positive bias voltage to reduce the threshold voltage of the memory layer 13 again after the application of a negative bias voltage.

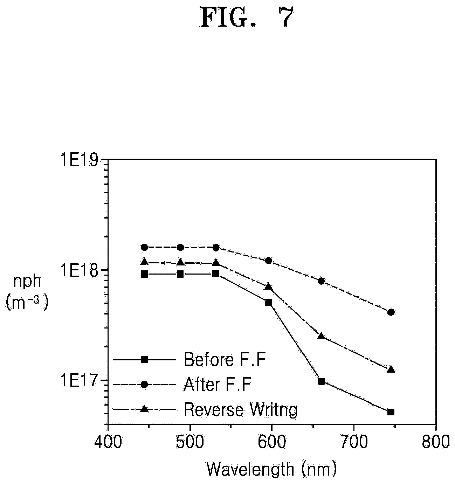

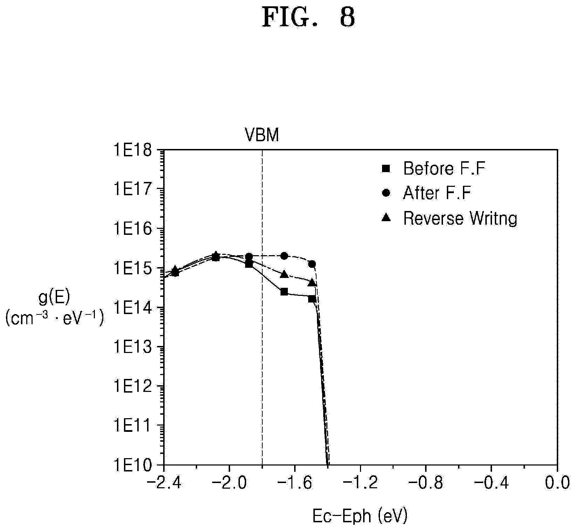

FIGS. 7 and 8 are graphs respectively showing comparative examples of trap densities in the memory layer 13 in the pristine state, after the first-firing and after the application of a negative bias voltage.

The graph of FIG. 7 shows a result of analysis of the trap density according to an energy level in a bandgap of a material of the memory layer 13 obtained by measuring the energy excited by photons by irradiating light having a wavelength of between 430 nm to 750 nm to the memory device 10. In FIG. 7, the vertical axis indicates a photo carrier concentration. Referring to FIG. 7, it may be seen that, in the pristine state (before first-firing), the trap density is the lowest, after the first-firing, the trap density increases, and after the application of a negative bias voltage in reverse writing, the trap density decreases. Furthermore, it may be seen that the trap density after the application of a negative bias voltage is greater than the trap density in the pristine state.

Furthermore, FIG. 8 is a graph showing analysis results obtained in the same manner as those of FIG. 7 as a relationship between the photon energy and the density of a state. In FIG. 8, the horizontal axis indicates an energy level to photon energy irradiated to the memory device 10, based on the conduction band energy of the material of the memory layer 13. For example, the horizontal axis indicates a difference between conduction band energy Ec and energy Eph of the irradiated light. In FIG. 8, the vertical axis indicates the density of a state. Referring to FIG. 8, it may be seen that, in the pristine state before first-firing, after the first-firing, and after the application of a negative bias voltage with reverse writing, the density of a state of the memory layer 13 is almost identical within the valence band. A difference in the density of a state of the memory layer 13 between the pristine state before first-firing, after the first-firing, and after the application of a negative bias voltage with reverse writing starts to appear at around a valence band maximum (VBM). In particular, it may be seen that the density of a state in the pristine state before first-firing is the lowest, the density of a state after the first-firing is the highest, and the density of a state after the application of a negative bias voltage with reverse writing is higher than the density of a state in in the pristine state before first-firing and lower than the density of a state after the first-firing. Furthermore, it may be seen that, within a bandgap between the valence band and the conduction band, as the energy of the irradiated light approaches the conduction band energy, the density of a state is rapidly reduced.

It may be confirmed through the graphs of FIGS. 7 and 8 that active traps having an energy distribution slightly lower than the Fermi level exist in the bandgap, and that the density of active traps is changed in the pristine state, after the first-firing, and after the application of a negative bias voltage. Accordingly, it may be confirmed that the threshold voltage shift of the memory layer 13 of the memory device 10 according to various example embodiments is a phenomenon occurring due to a change in the density of active traps in the memory layer 13.

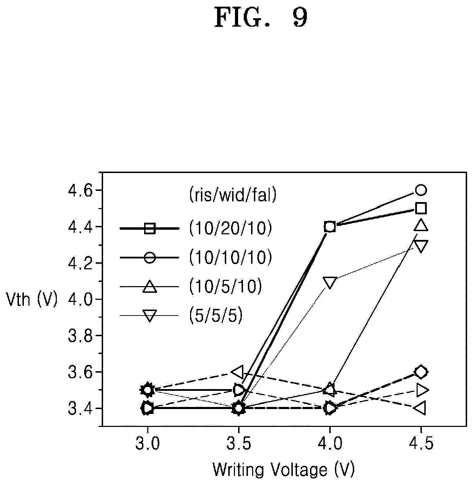

As the change in the density of active traps may occur at a relatively fast speed, the memory device 10 using the phenomenon may have a relatively fast driving speed. FIG. 9 is a graph showing an example of a relationship between a threshold voltage of the memory layer 13 and the intensity and pulse width of a bias voltage. In particular, FIG. 9 shows an example of the threshold voltage change when positive bias voltages and negative bias voltages, each having various waveforms, are applied to the memory layer 13 in a state of after the first-firing.

In the graph of FIG. 9, "ris" denotes a time width in a pulse rising period, "wid" denotes a time width of a pulse peak, "fal" denotes a time width of a pulse falling period, and the unit is nanoseconds (nsec). Furthermore, in the graph of FIG. 9, a solid line indicates a threshold voltage change by a negative bias voltage, and a dashed line indicates a threshold voltage change by a positive bias voltage. Furthermore, in the graph of FIG. 9, the horizontal axis indicates the absolute value of a bias voltage. Thus, in the graph indicated by a solid line, the horizontal axis has a negative value, and in the graph indicated by a dashed line, the horizontal axis has a positive value.

Referring to FIG. 9, regardless of the pulse width at the peak, when a negative bias voltage having an absolute value of about -4.5 V or more is applied to the memory layer 13, the threshold voltage of the memory layer 13 is greatly increased. For example, a threshold voltage when a bias voltage of about -4.5 V is applied for 5 nsec is about 4.4 V, a threshold voltage when the same bias voltage is applied for about 10 nsec is about 4.6 V, and a threshold voltage when the same bias voltage is applied for about 20 nsec is about 4.5 V. Furthermore, when the pulse widths of a rising period and a falling period are short as 5 nsec, regardless of the pulse width at the peak, the threshold voltage of the memory layer 13 is greatly increased with a bias voltage of about -4.0 V. Accordingly, a pulse width of about 20 nsec or less, or about 10 nsec or less is sufficient for the pulse width at the peak of a negative bias voltage applied to the memory layer 13. In this regard, the memory device 10 according to various example embodiments may have a relatively fast driving speed of about 20 nsec or less, about 10 nsec or less, or less than about 10 nsec. Such a fast driving speed may be possible because the memory layer 13 is driven in a manner of changing the density of active traps in the memory layer 13 according to the polarity and the intensity of a bias voltage.

Furthermore, as it may be seen through the graph of FIG. 9, when a positive bias voltage is applied to the memory layer 13 in a state of after the first-firing, there is little change in the threshold voltage. Accordingly, the threshold voltage change of the memory layer 13 may be dependent on the polarity of the applied bias voltage. For example, in the first state in which the threshold voltage is relatively low, even when a positive bias voltage is applied to the memory layer 13, the threshold voltage of the memory layer 13 is hardly changed, and when a negative bias voltage is applied thereto, the threshold voltage of the memory layer 13 may be increased. Furthermore, in the second state in which the threshold voltage is relatively high, only when a positive bias voltage greater than the threshold voltage is applied to the memory layer 13, the threshold voltage of the memory layer 13 may be lowered. Accordingly, when a voltage between the threshold voltage in the first state and the threshold voltage in the second state is selected as a read voltage, it may be checked whether the memory layer 13 is in the first state or the second state without changing the threshold voltage of the memory layer 13.

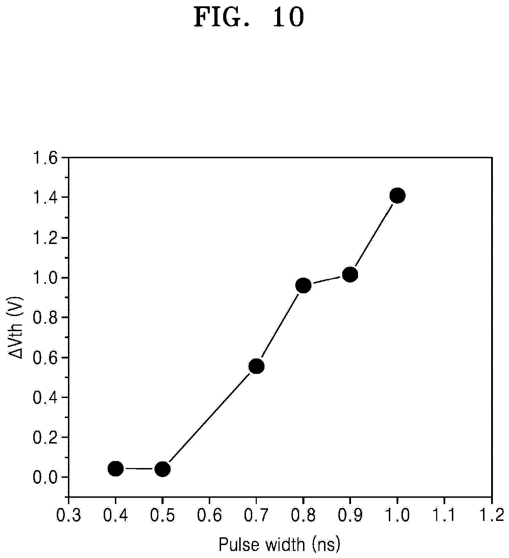

FIG. 10 is a graph showing an example of a threshold voltage of a memory layer 13 when fixing the intensity of a bias voltage and changing a pulse width of the bias voltage. The graph of FIG. 10 is obtained by applying a bias voltage of -10 V, which has a greater absolute value than -4.5 V, to the memory layer 13. In the graph of FIG. 10, the pulse width indicated in the horizontal axis denotes a time width of a pulse peak. Referring to FIG. 10, in a case where a bias voltage of about -10 V is applied to the memory layer 13, the threshold voltage of the memory layer 13 starts to change when the pulse width at the peak of the bias voltage is about 0.5 nsec or more, and the threshold voltage of the memory layer 13 increases by about 0.55 V when the pulse width at the peak of the bias voltage is about 0.7 nsec. Further, the threshold voltage more greatly increases as the pulse width at the peak of the bias voltage increases.

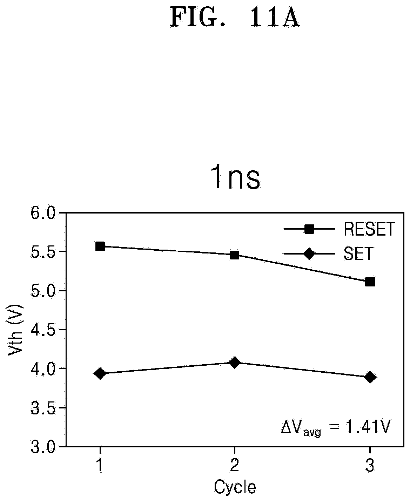

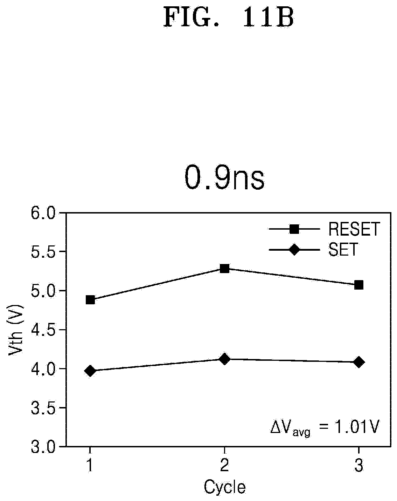

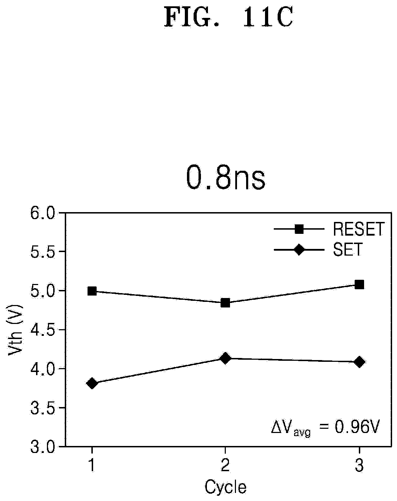

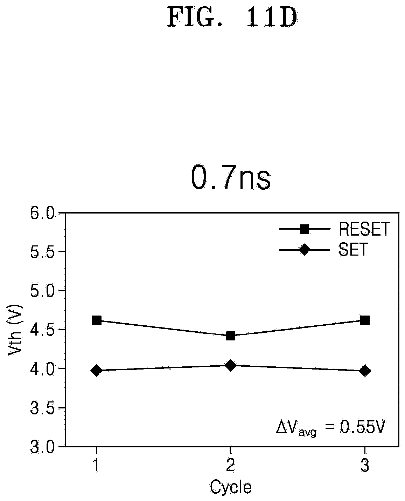

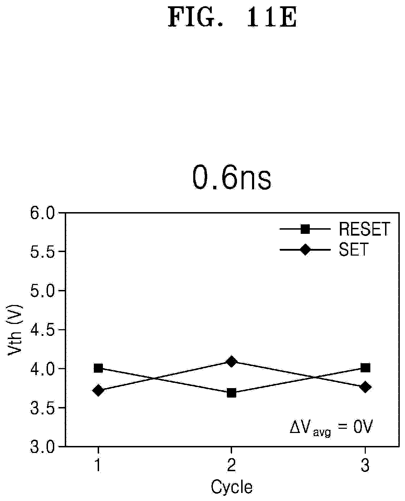

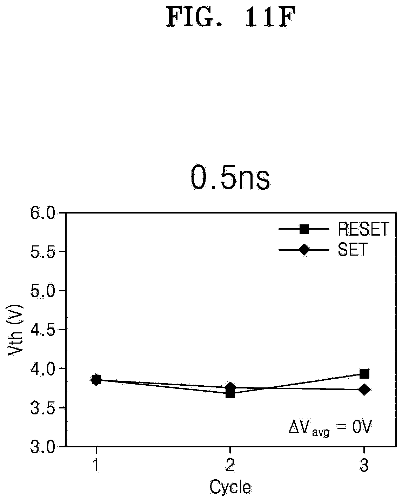

FIGS. 11A, 11B, 11C, 11D, 11E, and 11F are graphs showing examples of a change in the difference between the threshold voltage of the memory layer 13 in a first state and the threshold voltage of the memory layer 13 in a second state when a reset operation and a set operation are repeatedly performed by using a bias voltage having various pulse widths. The graphs of FIGS. 11A, 11B, 11C, 11D, 11E, and 11F are obtained by repeatedly performing three times a reset operation using a bias voltage of -10 V and a set operation using a bias voltage of +10 V. Furthermore, in FIGS. 11A, 11B, 11C, 11D, 11E, and 11F, the pulse width at the peak of a bias voltage was 1 nsec, 0.9 nsec, 0.8 nsec, 0.7 nsec, 0.6 nsec, and 0.5 nsec, respectively. In the graphs of FIGS. 11A, 11B, 11C, 11D, 11E, and 11F, ΔV_{avg} denotes a three-time average of the difference between the threshold voltage of the memory layer 13 in the first state and the threshold voltage of the memory layer 13 in the second state. Referring to FIGS. 11E and 11F, when the pulse width at the peak is 0.5 nsec and 0.6 nsec, the threshold voltage of the memory layer 13 in the first state and the threshold voltage of the memory layer 13 in the second state were hardly distinguished. In contrast, referring to FIGS. 11A, 11B, 11C, and 11D, when the pulse width at the peak is 0.7 nsec or more, the threshold voltage of the memory layer 13 in the first state and the threshold voltage of the memory layer 13 in the second state were clearly distinguished.

Considering the test results described above, the pulse width at the peak of a negative bias voltage applied to the memory layer 13 may be sufficiently about 0.7 nsec. For example, the pulse width at the peak of a negative bias voltage applied to the memory layer 13 may be about 0.7 nsec or more and about 20 nsec or less, about 0.7 nsec or more and about 10 nsec or less, about 0.7 nsec or more and less than 10 nsec, or about 0.7 nsec or more and about 5 nsec or less. In this regard, the memory device 10 according to embodiment may have a relatively fast driving speed of about 0.7 nsec or more and about 20 nsec or less, about 0.7 nsec or more and about 10 nsec or less, about 0.7 nsec or more and less than 10 nsec, or about 0.7 nsec or more and about 5 nsec or less. Furthermore, in the negative bias voltage applied to the memory layer 13, the pulse width at a rising edge and a falling edge may be about 10 nsec or less or about 5 nsec or less, and may be equal to or less than the pulse width at the peak.

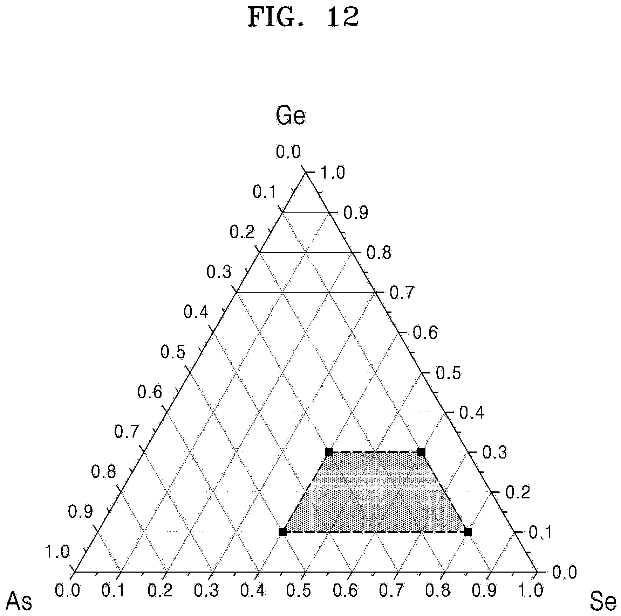

FIG. 12 is a graph showing an example of an element composition ratio of a material of the memory layer 13 according to various example embodiments. For example, when GeAsSe is used as a material of the memory layer 13, an atomic percentage of germanium (Ge) in the memory layer 13 may be about 10 at% or more and about 30 at% or less, an atomic percentage of arsenic (As) may be about 10 at% or more and about 50 at% or less, and an atomic percentage of Se may be about 40 at% or more and about 80 at% or less. FIG. 12 illustrates an example of a composition ratio when GeAsSe is used as a material of the memory layer 13, and a case of using a different material is not limited thereto and the composition ratio thereof may be slightly changed. In various example embodiments embodiment, as traps are mainly formed by a Se element, even when a different material is used, an atomic percentage of Se in the material of the memory layer 13 may be about 40 at% or more.

Additionally or alternatively, if a germanium (Ge) ratio is increased then leakage values may be increased, while if the Ge ratio is decreased thermal stability may be weakened. Additionally or alternatively, if an arsenic (As) ratio is decreased, a stability of an amorphous structure may be weakened.

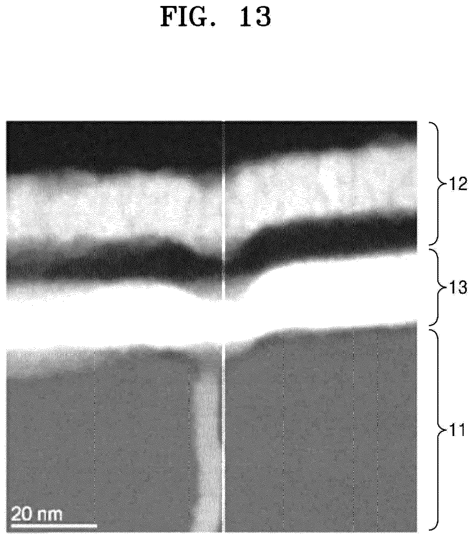

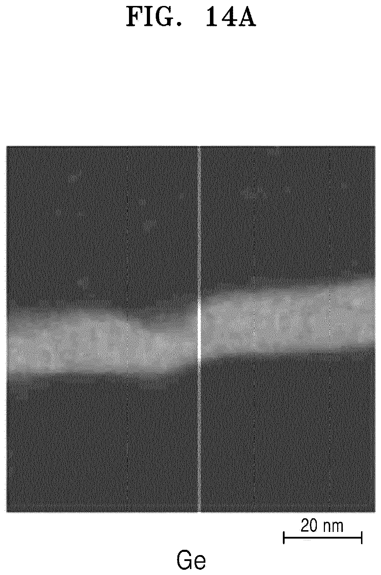

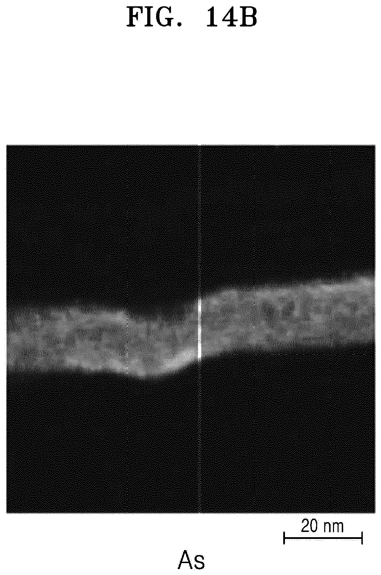

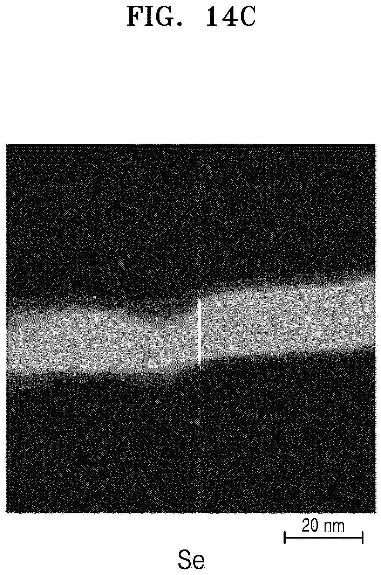

FIG. 13 illustrates an example of a transmission electron microscope (TEM) image of an actually manufactured memory device. Furthermore, FIGS. 14A, 14B, and 14C illustrate examples of an element mapping result with respect to the memory layer 13 of the memory device illustrated in FIG. 13. FIGS. 13-14C illustrate an actually manufactured memory device wherein the memory layer 13 is GeAsSeln. In particular, FIGS. 14A, 14B, and 14C illustrate a distribution of Ge elements, a distribution of As elements, and a distribution of Se elements in the memory layer 13 after a negative (-) bias voltage is applied to the memory layer 13 that is first-fired. Referring to FIGS. 14A, 14B, and 14C, it may be seen that, in the total area inside the memory layer 13, a change in the distribution of Ge elements, a change in the distribution of As elements, and a change in the distribution of Se elements are not great. For example, it may be checked that, even after a negative (-) bias voltage is applied to the memory layer 13 that is first-fired, in the total area inside the memory layer 13, Ge elements, As elements, and Se elements are generally uniformly distributed. In particular, a composition gradient of Se elements hardly appears in the memory layer 13. Referring to the element mapping result of FIGS. 14A, 14B, and 14C, it may be seen that the threshold voltage shift of the memory layer 13 of the memory device 10 according to embodiment is not generated by an ion migration phenomenon of Se atoms in the memory layer 13, but by a phenomenon generated by a change in the density of an active trap.

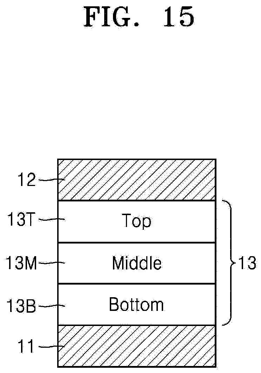

In order to additionally check that the threshold voltage shift of the memory layer 13 is not generated by the ion migration phenomenon, three memory layer samples were manufactured. After each memory layer sample is equally divided into three parts with the same thickness, the concentration of Se was measured in each thickness region. For example, FIG. 15 illustrates examples of a bottom region, a middle region, and a top region that equally divide the memory layer 13 according to various example embodiments into three parts with the same thickness. Referring to FIG. 15, the memory layer 13 was divided into a bottom region 13B close to the first electrode 11, a top region 13T close to the second electrode 12, and a middle region 13M between the bottom region 13B and the top region 13T, and the concentration of Se was measured in each region.

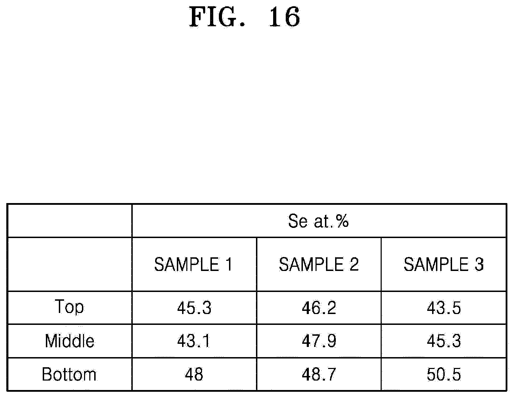

FIG. 16 illustrates an example of the concentration of Se in the bottom region 13B, the middle region 13M, and the top region 13T of the three actually manufactured memory layer samples. FIG. 16 illustrates an example where the memory layer is composed of GeAsSeln, and an atomic concentration of In is 10%. In FIG. 16, the concentration of Se was measured using an energy dispersive X-Ray spectroscopy (EDS). Sample 1 and sample 3 are memory layer samples before first-firing, and sample 2 is a memory layer sample in a state in which a negative bias voltage is applied after the first-firing. Although the Se concentration of the bottom region 13B was measured to be highest in all three samples, considering a measurement error, it may not be seen that the Se concentration of the bottom region 13B is significantly higher than the Se concentration of the other regions. In particular, when the threshold voltage shift of the memory layer 13 is generated by the ion migration phenomenon, the Se concentration should be increased greatly in the bottom region 13B of sample 2. However, the Se concentration in the bottom region 13B of sample 2 had no big difference from the Se concentration in the bottom region 13B of sample 1 and sample 3. Rather, the Se concentration in the bottom region 13B of sample 3 was higher than the Se concentration in the bottom region 13B of sample 2. In this regard, in a state before the first-firing, a state after the first-firing, and a state in which a negative bias voltage is applied after the first-firing, it may be analogized that there is no significant change in the Se concentration in the bottom region 13B, the middle region 13M, and the top region 13T of the memory layer 13. Accordingly, it may be seen that the threshold voltage shift of the memory layer 13 is generated not by the ion migration phenomenon, but by the change in the density of an active trap.

In the experimental example of FIGS. 15 and 16, it may be seen that the top region 13T may generally correspond to the second region 13b of FIG. 5A, and the middle region 13M and the bottom region 13B may generally correspond to the first region 13a of FIG. 5A. Then, when the memory layer 13 according to various example embodiments is changed from the first state to the second state or from the second state to the first state, it may be seen that a ratio of Ge, As, and Se may be maintained constant in the first region 13a and the second region 13b of the memory layer 13. In particular, it may be seen that there is hardly a difference between the Se concentration in the first region 13a when the memory layer 13 is in the first state and the Se concentration in the first region 13a when the memory layer 13 is in the second state. For example, a difference (C1-C2) between a Se concentration C1 in the first region 13a when the memory layer 13 is in the first state and the Se concentration C2 in the first region 13a when the memory layer 13 is in the second state may be within 10% of the Se concentration C1 in the first region 13a when the memory layer 13 is in the first state.

As can be analogized through the tests described above, in the the memory device 10 according to various example embodiments, when the threshold voltage of the memory layer 13 is changed, an element composition distribution may be substantially maintained constant in the memory layer 13. The expression that the element composition distribution is "maintained constant" may mean a degree that there is no significant change in the concentration of each of the elements included in the memory layer 13, for example, in the first region 13a and the second region 13b of the memory layer 13. In detail, the expression that the element composition distribution is "maintained constant" may include a case in which a difference in the concentration of each of the elements included in the first region 13a and the second region 13b of the memory layer 13 is within 10% when the memory layer 13 is in the first state and the second state.

As described above, the memory device 10 according to various example embodiments may perform both a memory function and a selector function with only a single material by using a phenomenon of a change in the density of active traps according to the polarity and the intensity of a bias voltage. Accordingly, a unit memory cell of a memory apparatus may be implemented with only one memory device without a separate selector. Alternatively or additionally, a memory apparatus including the memory device 10 according to various example embodiments, which has a small aspect ratio of a unit memory cell, may be manufactured through a relatively simple process, and may have improved memory capacity. Alternatively or additionally, for the memory device 10 according to various example embodiments, driving is possible with a very short pulse width. Accordingly, a memory apparatus including the memory device 10 according to various example embodiments may have an improved driving speed.

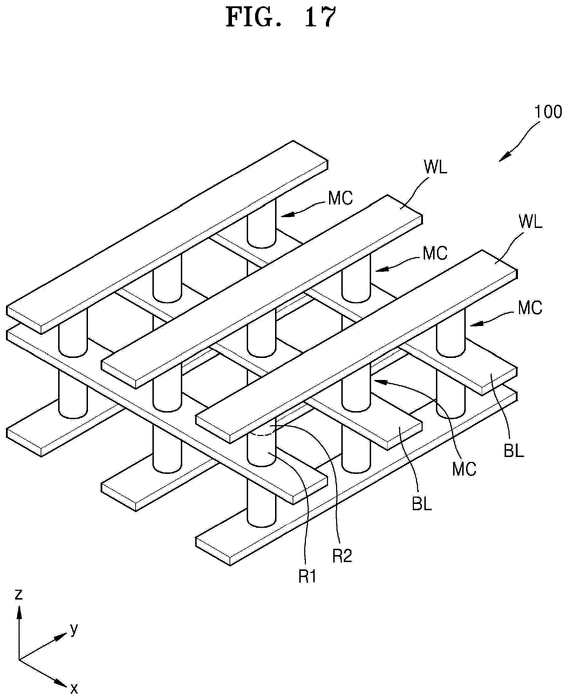

FIG. 17 is a schematic perspective view of the structure of a memory apparatus 100 according to various example embodiments. Referring to FIG. 17, the memory apparatus 100 may have a three-dimensional cross-point structure. For example, the memory apparatus 100 may include a plurality of bit lines BL extending in a first direction, for example, an x-axis direction, a plurality of word lines WL extending in a second direction, for example, a y-axis direction, crossing the first direction, and a plurality of memory cells MC provided at intersections where the bit lines BL and the word lines WL cross each other. Each of the memory cells MC may have a rod shape and correspond to the memory layer 13 of the memory device 10 illustrated in FIG. 1. Accordingly, each of the memory cells MC may have the same characteristics as the memory layer 13 of the memory device 10 illustrated in FIG. 1. Furthermore, each of the bit lines BL may correspond to the first electrode 11 of the memory device 10 illustrated in FIG. 1, and each of the word lines WL may correspond to the second electrode 12 of the memory device 10 illustrated in FIG. 1.

In such a structure, each of the memory cells MC may be driven by a potential difference between the word line WL and the bit line BL connected to the opposite ends of each memory cell MC. For example, in a state in which the memory cell MC is in a first state having a relatively low first threshold voltage, when the potential difference between the word line WL and the bit line BL is -4 V or more, the memory cell MC may be changed to a second state having a relatively high second threshold voltage. Furthermore, in a state in which the memory cell MC is in the second state having a relatively high second threshold voltage, when the potential difference between the word line WL and the bit line BL is greater than or equal to the second threshold voltage, for example, +4 V or more, the memory cell MC may be changed to the first state having a relatively low first threshold voltage. When data recorded in the memory cell MC is to be read, the potential difference between the word line WL and the bit line BL is between the first threshold voltage and the second threshold voltage, for example, about +3 V to about +3.5 V. Furthermore, a driving speed of the memory apparatus 100 according to various example embodiments may be, for example, about 0.7 nsec or more and about 20 nsec or less, about 0.7 nsec or more and about 10 nsec or less, or about 0.7 nsec or more and about 5 nsec or less.

Furthermore, referring back to FIGS. 5A and 6A, each of the memory cells MC may have a first region R1 in contact with a corresponding bit line of the bit lines BL and a second region R2 in contact with a corresponding word line of the word lines WL. When the memory cell MC is in the first state, the density of active traps in the second region R2 may be greater than the density of active traps in the first region R1. In contrast, when the memory cell MC is in the second state, the density of active traps in the second region R2 may be less than the density of active traps in the first region R1.

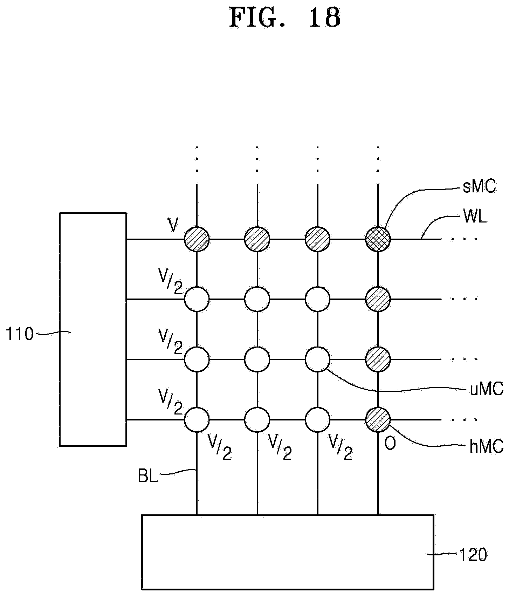

FIG. 18 is a circuit diagram showing an example of an operation of selecting a specific memory cell in the memory apparatus 100 illustrated in FIG. 17. Referring to FIG. 18, the memory apparatus 100 may further include a row decoder 110 for selectively providing a voltage to the word lines WL and a column decoder 120 for selectively providing a voltage to the bit lines BL. When a voltage of V is applied to one selected memory cell sMC selected from among the memory cells MC, the row decoder 110 may provide the voltage of V to the word line WL connected to the selected memory cell sMC and provide a voltage of V/2 to the other word lines WL. In this state, the column decoder 120 may provide a voltage of 0 V to the bit line BL connected to the selected memory cell sMC and provide the voltage of V/2 to the other bit line BL.

Then, a potential difference between the word line WL and the bit line BL of the selected memory cell sMC is V. In contrast, a potential difference between the word line WL through which the voltage of V/2 is provided and the bit line BL through which the voltage of V/2 is provided is 0 V. Accordingly, no voltage is applied to an unselected memory cell uMC arranged between the word line WL and the bit line BL that are not connected to the selected memory cell sMC. The voltage of V/2 may be applied to the opposite ends of a half-selected memory cell hMC connected to the word line WL to which the selected memory cell sMC is connected or the bit line BL to which the selected memory cell sMC is connected. The memory cell MC according to various example embodiments may be a self-selecting memory device having a threshold voltage, as described above Accordingly, the half-selected memory cell hMC neighboring the selected memory cell sMC is not turned on even when the voltage of V/2 is applied thereto, and as a result, a sneak current rarely occurs.

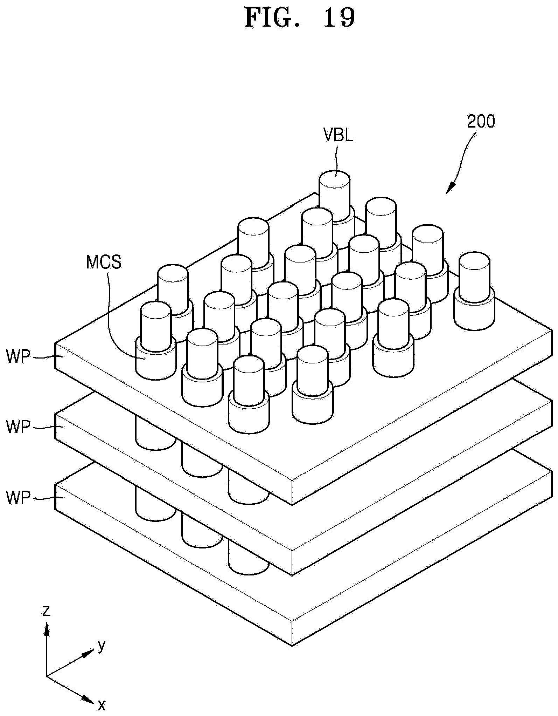

FIG. 19 is a schematic perspective view of the structure of a memory apparatus 200 according to various example embodiments. Referring to FIG. 19, the memory apparatus 200 may include a plurality of word planes WP extending along a plane including a first direction and a second direction and arranged apart from each other in a third direction, for example, a z-axis direction, crossing the first direction and the second direction, a plurality of vertical bit lines VBL extending in the third direction and arranged two-dimensionally in the first direction and the second direction, and a plurality of memory cell strings MCS surrounding surfaces of the vertical bit lines VBL and extending in the third direction. The memory cell strings MCS may be two-dimensionally arranged in the first direction and the second direction, like the vertical bit lines VBL. Each of the memory cell strings MCS and each of the vertical bit lines VBL may be arranged to penetrate the word planes WP in the third direction. As each of the memory cell strings MCS extends in a vertical direction, the memory apparatus 200 illustrated in FIG. 19 may be referred to as a vertical memory apparatus, and may have a further improved memory capacity. Each of the memory cell strings MCS may include the same material as the memory layer 13 of the memory device 10 illustrated in FIG. 1.

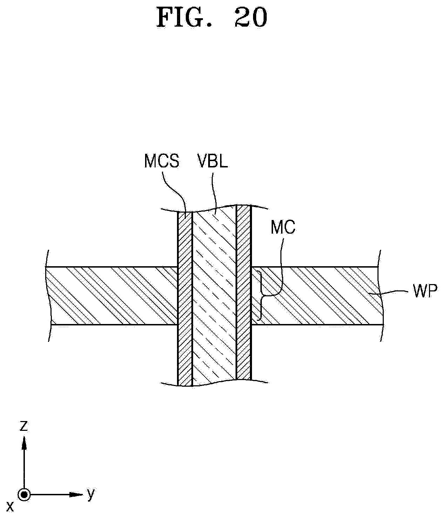

FIG. 20 is a schematic vertical cross-sectional view of the configuration of one memory cell in the memory apparatus 200 illustrated in FIG. 19. Referring to FIG. 20, in each of the memory cell strings MCS extending in the third direction, an area surrounded by one word plane WP may form one memory cell MC. Accordingly, one memory cell string MCS may include a plurality of memory cells MC arranged apart from each other in the third direction. Each of the memory cells MC may correspond to the memory layer 13 of the memory device 10 illustrated in FIG. 1, and have the same characteristics as the memory layer 13 of the memory device 10 illustrated in FIG. 1.

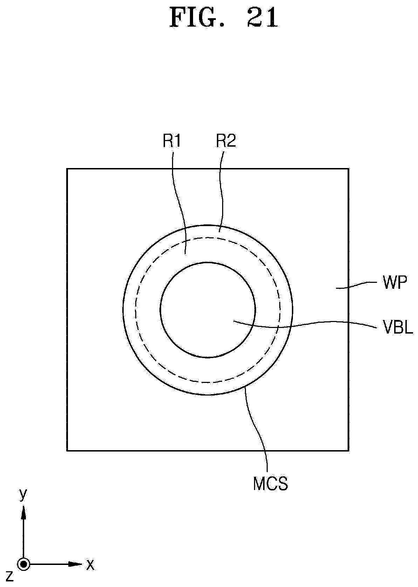

FIG. 21 is a schematically horizontal cross-sectional view of the configuration of one memory cell MC of the memory apparatus 200 illustrated in FIG. 19. Referring to FIG. 21, one memory cell MC may have a ring shape. Furthermore, the memory cell MC may include the first region R1 having a ring shape in contact with a corresponding vertical bit line of the plurality of vertical bit lines VBL and surrounding the corresponding vertical bit line, and the second region R2 having a ring shape and surrounding the first region R1. The second region R2 may be in contact with a corresponding word plane of the plurality of word planes WP and surrounded by the corresponding word plane. The first region R1 and the second region R2 may be concentrically arranged. The first region R1 may correspond to the first region 13a illustrated in FIGS. 5A and 6A, and the second region R2 may correspond to the second region 13b illustrated in FIGS. 5A and 6A. Accordingly, when the memory cell MC is in the first state having a relatively low threshold voltage, the density of active traps in the second region R2 may be greater than the density of active traps in the first region R1. When the memory cell MC is in the second state having a relatively high threshold voltage, the density of active traps in the second region R2 may be less than the density of active traps in the first region R1. Furthermore, the radial width of the second region R2 may be less than the radial width of the first region R1.

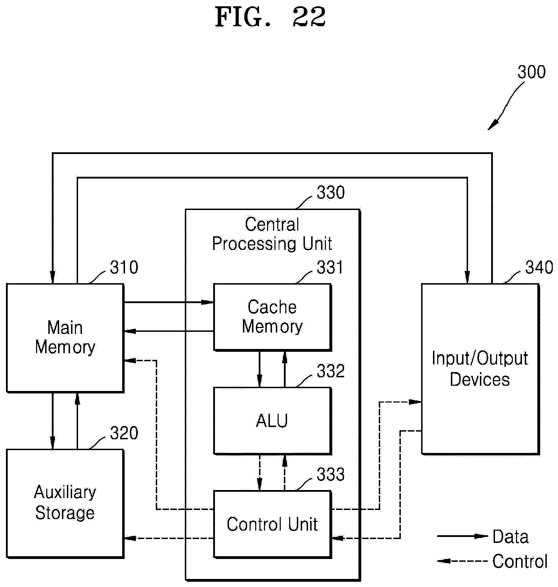

The memory apparatuses 100 and 200 described above may be used to store data in various electronic apparatuses. FIG. 22 is a schematic conceptual view of a device architecture applicable to an electronic apparatus 300 according to embodiments. Referring to FIG. 22, the electronic apparatus 300 may include a main memory 310, an auxiliary storage 320, a central processing unit (CPU) 330, and an input/output device 340. The CPU 330 may include a cache memory 331, an arithmetic logic unit (ALU) 332, and a control unit 333. The cache memory 331 may include a static random access memory (SRAM). The main memory 310 may include a DRAM device, and the auxiliary storage 320 may include the memory apparatus 100 or 200 according to various example embodiments. Alternatively or additionally, the cache memory 331, the main memory 310, and the auxiliary storage 320 may all include the memory apparatus 100 or 200 according to various example embodiments. In some cases, the electronic apparatus 300 may be implemented in the form of computing unit devices and memory unit devices being adjacent to each other in one chip, without distinction of the sub-units described above.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

The self-selecting memory device using a polarity dependent threshold voltage shift method described above, and/or the memory apparatus including the same, are described based on variously described example embodiments illustrated in the drawings, it should be understood that embodiments described herein should be considered in a descriptive sense only and not for purposes of limitation. Descriptions of features and/or aspects within each embodiment should typically be considered as available for other similar features or aspects in other embodiments. While one or more example embodiments have been described with reference to the figures, it will be understood by those of ordinary skill in the art that various changes in form and details may be made therein without departing from the scope as defined by the following claims.

## Claims

1. A memory apparatus (200) comprising:
a plurality of word planes (WP) extending along a plane defined by a first direction (x) and a second direction (y) and apart from each other in a third direction (z) crossing the first direction and the second direction;
a plurality of vertical bit lines (VBL) extending in the third direction and arranged two-dimensionally in the first direction and the second direction; and
a plurality of memory cell strings (MCS) surrounding surfaces of the plurality of vertical bit lines and extending in the third direction, wherein
the plurality of memory cell strings and the plurality of vertical bit lines are arranged to penetrate the plurality of word planes in the third direction,
an area surrounded by one of the plurality of word planes in each of the plurality of memory cell strings corresponds to one memory cell (MC),
the memory cell has Ovonic threshold switching characteristics,
the memory cell is configured to have a threshold voltage of the memory cell be changed as a density of active traps in the memory cell is changed, the threshold voltage changed according to a polarity and an intensity of a bias voltage applied to the memory cell, and
**characterized in that** an element composition distribution is configured to be maintained constant in the memory cell in response to the threshold voltage of the memory cell being changed.

2. The memory apparatus of claim 1, wherein the memory cell is configured to be in any one of a first state having a first threshold voltage and a second state having a second threshold voltage greater than the first threshold voltage.

3. The memory apparatus of claim 2, wherein the memory cell comprises a first region adjacent to a corresponding vertical bit line of the plurality of vertical bit lines and a second region adjacent to a corresponding word plane of the plurality of word planes.

4. The memory apparatus of claim 3, wherein in response to the memory cell being in the first state, a density of active traps in the second region is greater than a density of active traps in the first region.

5. The memory apparatus of claim 3, wherein in response to the memory cell being in the second state, the density of active traps in the second region is less than the density of active traps in the first region.

6. The memory apparatus of claim 3, wherein the density of active traps in the first region and the density of active traps in the second region in response to the memory cell being in the second state are respectively less than the density of active traps in the first region and the density of active traps in the second region in response to the memory cell being in the first state.

7. The memory apparatus of any of claims 3 to 6, wherein the first region and the second region have a ring shape and are concentrically arranged, and
wherein a radial width of the second region is less than a radial width of the first region.

8. The memory apparatus of any of claims 2 to 7, wherein in response to the memory cell being in the first state, the memory cell is configured to be converted into the second state by applying a negative bias voltage to the memory cell.

9. The memory apparatus of claim 8, wherein a pulse width at a peak of the negative bias voltage applied to the memory cell is 0.7 nsec or more and less than 10 nsec.

10. The memory apparatus of any of claims 2 to 7, wherein in response to the memory cell being in the second state, the memory cell is configured to be converted into the first state by applying a positive bias voltage greater than or equal to the second threshold voltage to the memory cell.

11. The memory apparatus of any of claims 2 to 10, wherein the memory apparatus is configured to operate such that in a read operation, a read voltage between the first threshold voltage and the second threshold voltage is applied to the memory cell.

12. The memory apparatus of any preceding claim, wherein the memory cell comprises a single layer comprising at least one material of GeAsSeln, GeAsSeSIn, GeAsSeSbln, GeAsSeTeln, GeAsSeAlln, GeSbSeln, and GeSbSeNIn, and
wherein a concentration of indium (In) in the memory cell is 10 at% or less.

13. The memory apparatus of any of claims 3 to 11, wherein
the memory cell comprises a single layer comprising GeAsSe, and
in the memory cell, an atomic percent of germanium (Ge) is 10 at% or more and 30 at% or less, an atomic percent of arsenic (As) is 10 at% or more and 50 at% or less, and an atomic percent of selenium (Se) is 40 at% or more and 80 at% or less.

14. The memory apparatus of claim 13, wherein in response to the memory cell being changed from the first state to the second state or from the second state to the first state, the memory device is configured such that a ratio of Ge, As, and Se is maintained constant in the first region and the second region of the memory cell.

15. The memory apparatus of claim 13, wherein a difference between a concentration of Se in the first region in response to the memory cell being in the first state and the concentration of Se in the first region in response to the memory cell being in the second state is within 10% of the concentration of Se in the first region in response to the memory cell being in the first state.

## Patentansprüche

1. Speichervorrichtung (200), umfassend:
eine Vielzahl von Wortebenen (WP), die sich entlang einer Ebene, die durch eine erste Richtung (x) und eine zweite Richtung (y) definiert ist, und beabstandet voneinander in einer dritten Richtung (z), welche die erste Richtung und die zweite Richtung kreuzt, erstreckt;
eine Vielzahl von vertikalen Bitleitungen (VBL), die sich in der dritten Richtung erstreckt und zweidimensional in der ersten Richtung und der zweiten Richtung angeordnet ist; und
eine Vielzahl von Speicherzellenstrings (MCS), die Oberflächen der Vielzahl von vertikalen Bitleitungen umgibt und sich in der dritten Richtung erstreckt, wobei
die Vielzahl von Speicherzellenstrings und die Vielzahl von vertikalen Bitleitungen angeordnet sind, um die Vielzahl von Wortebenen in der dritten Richtung zu durchdringen,
ein Bereich, der durch eine aus der Vielzahl von Wortebenen in jedem aus der Vielzahl von Speicherzellenstrings umgeben ist, einer Speicherzelle (MC) entspricht,
die Speicherzelle Ovonic-Schwellenschalteigenschaften aufweist,
die Speicherzelle dazu konfiguriert ist, dass eine Schwellenspannung der Speicherzelle geändert wird, wenn eine Dichte von aktiven Fallen in der Speicherzelle geändert wird, wobei die Schwellenspannung gemäß einer Polarität und einer Intensität einer Vorspannung, die an die Speicherzelle angelegt wird, geändert wird, und
**dadurch gekennzeichnet, dass** eine Elementzusammensetzungsverteilung dazu konfiguriert ist, als Reaktion darauf, dass die Schwellenspannung der Speicherzelle geändert wird, in der Speicherzelle konstant gehalten zu werden.

2. Speichervorrichtung nach Anspruch 1, wobei die Speicherzelle dazu konfiguriert ist, in einem beliebigen von einem ersten Zustand mit einer ersten Schwellenspannung und einem zweiten Zustand mit einer zweiten Schwellenspannung, die größer als die erste Schwellenspannung ist, zu sein.

3. Speichervorrichtung nach Anspruch 2, wobei die Speicherzelle eine erste Region benachbart zu einer entsprechenden vertikalen Bitleitung aus der Vielzahl von vertikalen Bitleitungen und eine zweite Region benachbart zu einer entsprechenden Wortebene aus der Vielzahl von Wortebenen umfasst.

4. Speichervorrichtung nach Anspruch 3, wobei als Reaktion darauf, dass die Speicherzelle in dem ersten Zustand ist, eine Dichte von aktiven Fallen in der zweiten Region größer als eine Dichte von aktiven Fallen in der ersten Region ist.

5. Speichervorrichtung nach Anspruch 3, wobei als Reaktion darauf, dass die Speicherzelle in dem zweiten Zustand ist, die Dichte von aktiven Fallen in der zweiten Region weniger als die Dichte von aktiven Fallen in der ersten Region ist.

6. Speichervorrichtung nach Anspruch 3, wobei die Dichte von aktiven Fallen in der ersten Region und die Dichte von aktiven Fallen in der zweiten Region als Reaktion darauf, dass die Speicherzelle in dem zweiten Zustand ist, jeweils weniger als die Dichte von aktiven Fallen in der ersten Region und die Dichte von aktiven Fallen in der zweiten Region als Reaktion darauf sind, dass die Speicherzelle in dem ersten Zustand ist.

7. Speichervorrichtung nach einem der Ansprüche 3 bis 6, wobei die erste Region und die zweite Region eine Ringform aufweisen und konzentrisch angeordnet sind, und
wobei eine radiale Breite der zweiten Region weniger als eine radiale Breite der ersten Region ist.

8. Speichervorrichtung nach einem der Ansprüche 2 bis 7, wobei als Reaktion darauf, dass die Speicherzelle in dem ersten Zustand ist, die Speicherzelle dazu konfiguriert ist, durch Anlegen einer negativen Vorspannung an die Speicherzelle in den zweiten Zustand umgewandelt zu werden.

9. Speichervorrichtung nach Anspruch 8, wobei eine Impulsbreite bei einer Spitze der negativen Vorspannung, die an die Speicherzelle angelegt wird, 0,7 nsec oder mehr und weniger als 10 nsec ist.

10. Speichervorrichtung nach einem der Ansprüche 2 bis 7, wobei als Reaktion darauf, dass die Speicherzelle in dem zweiten Zustand ist, die Speicherzelle dazu konfiguriert ist, durch Anlegen einer positiven Vorspannung, die größer als die oder gleich der zweiten Schwellenspannung ist, an die Speicherzelle in den ersten Zustand umgewandelt zu werden.

11. Speichervorrichtung nach einem der Ansprüche 2 bis 10, wobei die Speichervorrichtung dazu konfiguriert ist, betrieben zu werden, sodass in einem Lesebetrieb eine Lesespannung zwischen der ersten Schwellenspannung und der zweiten Schwellenspannung an die Speicherzelle angelegt wird.

12. Speichervorrichtung nach einem vorhergehenden Anspruch, wobei die Speicherzelle eine einzelne Schicht umfasst, die zumindest ein Material aus GeAsSeIn, GeAsSeSIn, GeAsSeSbIn, GeAsSeTeln, GeAsSeAlIn, GeSbSeIn und GeSbSeNIn umfasst, und
wobei eine Konzentration von Indium (In) in der Speicherzelle 10 At.-% oder weniger ist.

13. Speichervorrichtung nach einem der Ansprüche 3 bis 11, wobei
die Speicherzelle eine einzelne Schicht umfasst, die GeAsSe umfasst, und
in der Speicherzelle ein Atomprozent von Germanium (Ge) 10 At.-% oder mehr und 30 At.-% oder weniger ist, ein Atomprozent von Arsen (As) 10 At.-% oder mehr und 50 At.-% oder weniger ist und ein Atomprozent von Selen (Se) 40 At.-% oder mehr und 80 At.-% oder weniger ist.

14. Speichervorrichtung nach Anspruch 13, wobei als Reaktion darauf, dass die Speicherzelle von dem ersten Zustand zu dem zweiten Zustand oder von dem zweiten Zustand zu dem ersten Zustand geändert wird, das Speichergerät konfiguriert ist, sodass ein Verhältnis von Ge, As und Se in der ersten Region und der zweiten Region der Speicherzelle konstant gehalten wird.

15. Speichervorrichtung nach Anspruch 13, wobei eine Differenz zwischen einer Konzentration von Se in der ersten Region als Reaktion darauf, dass die Speicherzelle in dem ersten Zustand ist, und der Konzentration von Se in der ersten Region als Reaktion darauf, dass die Speicherzelle in dem zweiten Zustand ist, innerhalb von 10 % der Konzentration von Se in der ersten Region als Reaktion darauf ist, dass die Speicherzelle in dem ersten Zustand ist.

## Revendications

1. Appareil de mémoire (200) comprenant :
une pluralité de plans de mots (WP) s'étendant le long d'un plan défini par une première direction (x) et une deuxième direction (y) et espacés les uns des autres dans une troisième direction (z) coupant la première direction et la deuxième direction ;
une pluralité de lignes de bits verticales (VBL) s'étendant dans la troisième direction et agencées en deux dimensions dans la première direction et la deuxième direction ; et
une pluralité de chaînes de cellules de mémoire (MCS) entourant des surfaces de la pluralité de lignes de bits verticales et s'étendant dans la troisième direction, dans lequel
la pluralité de chaînes de cellules de mémoire et la pluralité de lignes de bits verticales sont agencées pour pénétrer dans la pluralité de plans de mots dans la troisième direction,
une zone entourée par l'un de la pluralité de plans de mots dans chacune de la pluralité de chaînes de cellules de mémoire correspond à une cellule de mémoire (MC),
la cellule de mémoire a des caractéristiques de commutation de seuil ovonique,
la cellule de mémoire est configurée pour qu'une tension de seuil de la cellule de mémoire soit modifiée lorsqu'une densité de pièges actifs dans la cellule de mémoire est modifiée, la tension de seuil étant modifiée selon une polarité et une intensité d'une tension de polarisation appliquées à la cellule de mémoire, et
**caractérisé en ce qu'**une distribution de composition d'élément est configurée pour être maintenue constante dans la cellule de mémoire en réponse au fait que la tension de seuil de la cellule de mémoire est en cours de modification.

2. Appareil de mémoire de la revendication 1, dans lequel la cellule de mémoire est configurée pour être dans l'un quelconque d'un premier état ayant une première tension de seuil et d'un second état ayant une seconde tension de seuil supérieure à la première tension de seuil.

3. Appareil de mémoire de la revendication 2, dans lequel la cellule de mémoire comprend une première zone adjacente à une ligne de bits verticale correspondante de la pluralité de lignes de bits verticales et une seconde zone adjacente à un plan de mots correspondant de la pluralité de plans de mots.

4. Appareil de mémoire de la revendication 3, dans lequel en réponse au fait que la cellule de mémoire soit dans le premier état, une densité de pièges actifs dans la seconde zone est supérieure à une densité de pièges actifs dans la première zone.

5. Appareil de mémoire de la revendication 3, dans lequel en réponse au fait que la cellule de mémoire soit dans le second état, la densité de pièges actifs dans la seconde zone est inférieure à la densité de pièges actifs dans la première zone.

6. Appareil de mémoire de la revendication 3, dans lequel la densité de pièges actifs dans la première zone et la densité de pièges actifs dans la seconde zone en réponse au fait que la cellule de mémoire soit dans le second état sont respectivement inférieures à la densité de pièges actifs dans la première zone et à la densité de pièges actifs dans la seconde zone en réponse au fait que la cellule de mémoire soit dans le premier état.

7. Appareil de mémoire de l'une quelconque des revendications 3 à 6, dans lequel la première zone et la seconde zone ont une forme d'anneau et sont agencées concentriquement, et
dans lequel une largeur radiale de la seconde zone est inférieure à une largeur radiale de la première zone.

8. Appareil de mémoire de l'une quelconque des revendications 2 à 7, dans lequel en réponse au fait que la cellule de mémoire soit dans le premier état, la cellule de mémoire est configurée pour être convertie dans le second état en appliquant une tension de polarisation négative à la cellule de mémoire.

9. Appareil de mémoire de la revendication 8, dans lequel une largeur d'impulsion au niveau d'un pic de la tension de polarisation négative appliquée à la cellule de mémoire est de 0,7 nsec ou plus et inférieure à 10 nsec.

10. Appareil de mémoire de l'une quelconque des revendications 2 à 7, dans lequel en réponse au fait que la cellule de mémoire soit dans le second état, la cellule de mémoire est configurée pour être convertie dans le premier état en appliquant une tension de polarisation positive supérieure ou égale à la seconde tension de seuil à la cellule de mémoire.

11. Appareil de mémoire de l'une quelconque des revendications 2 à 10, dans lequel l'appareil de mémoire est configuré pour fonctionner de sorte que dans une opération de lecture, une tension de lecture entre la première tension de seuil et la seconde tension de seuil soit appliquée à la cellule de mémoire.

12. Appareil de mémoire de l'une quelconque des revendications précédentes, dans lequel la cellule de mémoire comprend une seule couche comprenant au moins un matériau parmi GeAsSeIn, GeAsSeSIn, GeAsSeSbIn, GeAsSeTeIn, GeAsSeAlIn, GeSbSeIn et GeSbSeNIn, et
dans lequel une concentration d'indium (In) dans la cellule de mémoire est de 10 % at ou moins.

13. Appareil de mémoire de l'une quelconque des revendications 3 à 11, dans lequel
la cellule de mémoire comprend une seule couche comprenant du GeAsSe, et
dans la cellule de mémoire, un pourcentage atomique de germanium (Ge) est de 10 % at ou plus et de 30 % at ou moins, un pourcentage atomique d'arsenic (As) est de 10 % at ou plus et de 50 % at ou moins, et un pourcentage atomique de sélénium (Se) est de 40 % at ou plus et de 80 % at ou moins.

14. Appareil de mémoire de la revendication 13, dans lequel en réponse au fait que la cellule de mémoire soit en cours de changement du premier état au second état ou du second état au premier état, le dispositif de mémoire est configuré de sorte qu'un rapport de Ge, d'As et de Se soit maintenu constant dans la première zone et la seconde zone de la cellule de mémoire.

15. Appareil de mémoire de la revendication 13, dans lequel une différence entre une concentration de Se dans la première zone en réponse au fait que la cellule de mémoire soit dans le premier état et la concentration de Se dans la première zone en réponse au fait que la cellule de mémoire soit dans le second état est dans les limites de 10 % de la concentration de Se dans la première zone en réponse au fait que la cellule de mémoire soit dans le premier état.
